# EUROPÄISCHE PATENTSCHRIFT

(11) **EP 1 754 069 B1**
(45) Veröffentlichungstag und Bekanntmachung des Hinweises auf die Patenterteilung: **24.10.2012**
(21) Anmeldenummer: 05740741.3
(22) Anmeldetag: 29.04.2005
(51) Int. Cl.: G01R 15/18, G01R 15/20

(54) **STROMSENSOR**
CURRENT SENSOR
CAPTEUR DE COURANT

(30) Priorität: 30.04.2004 DE 102004021495
(43) Veröffentlichungstag der Anmeldung: 21.02.2007
(73) Patentinhaber: Vacuumschmelze GmbH & Co. KG, 63450 Hanau (DE)
(72) Erfinder: PREUSSE, Norbert, 63755 Alzenau (DE)
(74) Vertreter: Schmuckermaier, Bernhard
(86) Internationale Anmeldenummer: PCT/EP2005/004663
(87) Internationale Veröffentlichungsnummer: WO 2005/106506

(56) Entgegenhaltungen:
- DE-A1- 3 613 991
- DE-A1- 3 715 789
- DE-B1- 2 825 397
- DE-B1- 2 834 499
- US-A- 3 812 428

## Beschreibung

Die Erfindung betrifft einen Strömsensor nach dem Oberbegriff des Patentanspruches 1.

Derartige Stromsensoren sind zum Biespiel aus der US-A-3812428 oder der DE 3715781A1 bekannt.

Zur Messung von Gleich- und Wechselströmen wird häufig das Kompensationsprinzip verwendet, bei dem das in einem Magnet kern vom Messstrom erzeugte Magnetfeld durch einen Kompensationsstrom in einer Sekundärwicklung kompensiert wird. Zur steuerung des Kompensationestromes ist im Magnetkreis ein Detektor vorgesehen, der die Abweichung vom Nullfeld erfasst. Der Sekundärstrom ist damit ein genaues Abbild des zu messenden Primärstromes. Derartige Kompensationsstromsenaoren sind beispielsweise aus der EP 0294590 B1 oder der EP 0960342 B1 bekannt. Vorteil derartiger Stromsensoren ist es, dass sie eine sehr hohe Genauigkeit haben und praktisch keinen Eingriff in den zu messenden Stromkreis erfordern. Als Nachteil steht dem gegenüber, dass kompensationsstromsensoren einen verhältnismäßig hohen Aufwand erfordern.

Untersuchungen zu Batteriemanagementmodulen, die an der Batteriepolklemme montiert werden und einen digitalen Ausgang zum Anschluss an Datenbusse (z. B. LIN-Bus oder CAN-Bus) aufweisen sollen, haben gezeigt, dass allein schon der in diesem Fall erforderliche Mikrocontroller mit Analog-Digital-Wandler, Referenzspannung und hochpräzisen Bürdenwiderständen einen erheblichen Kostenfaktor darstellt.

Um die geforderte Genauigkeit zu erreichen, wäre aber auch bei einer Lösung mit einem analogen Ausgang (z. B. Spannungsausgang) im Niederstrombereich insbesondere zur Hysterese-Ausmittelung immer noch ein Mikrocontroller notwendig. Außerdem ist ein analoger Ausgang störanfällig und es wird auf beiden Seiten eine Präzisiohsreferenz benötigt, um die Ausgangssignalbereiche von Sensor und Analog-Digital-Wandler im weiterverarbeitenden Steuergerät aufeinander abzustimmen.

Es werden auch Sensoren mit pulsweitenmoduliertem Ausgang (PWM-Ausgang) eingesetzt. Dabei wird ein pulsweitenmoduliertes Ausgangssignals (PWM-Ausgangssignal) durch Umwandlung eines linearen Ausgangssignals in ein pulsweitenmoduliertes Signal (PWM-Signal) erzeugte Ein PWM-Signal an sich ist sehr vorteilhaft, da es störsichier ist und sehr einfach und kostengünstig in einem Kontroller eines weiterverarbeitenden Steuergerätes ausgewertet werden kann, wobei insbesondere keine kostenintensiven Analog-Digital-Umsetzer und keine Präzisionsreferenzen benötigt werden. Allerdings ist die Vorgehensweise, aus einem linearen Ausgangssignal durch entsprechende Umsetzung ein pulsweitenmoduliertes Ausgangssignal zu erzeugen, in mehrerlei Hinsicht ungünstig. Da eine zusätzliche Stufe zur Umwandlung in ein pulsweitenmoduliertes Signal benötigt wird, bei der auch Präzisionskomponenten eingesetzt werden, werden erhebliche zusätzliche Kosten verursacht. Außerdem ist die genannte Lösung auch unter Zuverlässigkeits - und Sicherheitsgesichtspunlten problematisch. So ist beispielsweise ein Fehlerfall denkbar, bei dem das pulweitenmodulierte Signal mit einem Tastverhältnis von 1 zu 1 einen normalen Betriebszustand und keinen Primärstrom anzeigt, obwohl der Sensor davor ausgefallen ist und möglicherweise ein sehr hoher Primärstrom fließt.

Aufgabe der vorliegenden Erfindung ist es, einen weiter verbesserten Stromsensor anzugeben, der die vorgenaninten Nachteile nicht aufweist.

Die Aufgabe wird gelöst durch einen Stromsensor gemäß Patent-anspruch 1. Ausgestaltungen und Weiterbildungen des Erfindungsgedankens sind Gegenstand von Unteranaprtichen.

Vorteil der vorliegenden Erfindung ist dabei, dass die Erzeugung des PWM-Signals fest in die Sensorfunktion selbst integriert ist und daher die Kosten stark verringert werden und zum Anderen Störungen leicht erkannt werden können, da beispielsweise bei Totalauafall entweder kein Signal oder ein maximales Signal abgegeben werden. Darüber hinaus zeichnet sich der erfindungsgemäße Stromsensor durch einen geringen Bauelementeaufwand aus, was sich insbesondere in der Baugröße niederschlägt. Schließlich werden auch nachteilige Eigenschaften des magnetischen Moduls (beispielsweise Hysterese) ohne zusätzlichen Aufwand kompensiert.

Erreicht wird dies erfindungsgemaß durch einen Stromsensor mit einem magnetischen Modul, bei dem ein Primärleiter, eine Kompensationswicklung und eine Magrletfeldsonde magnetisch miteinander gekoppelt sind, wobei der Primärleiter, einen zu messenden Strom führt. Die Kompensationswicklung wird dabei durch eine Ansteuerschaltung gespeist, die einen dreieckförmigen Strom erzeugt. Schließlich ist noch eine Auswerteschaltung vorgesehen, die bei einem Nulldurchgang eines von der Magnetfeldsonde bereitgestellten Signales ihr Ausgangssignal von einen ersten auf einen zweiten Ausgangspegel und umgekehrt umschaltet, wobei das Ausgangsignal entsprechend der Stromstärke des zu messenden Stromes pulsweitenmoduliert ist. So kann die Auswerteschaltung beispielsweise entsprechend dem Vorzeichen des von der Magnetfeldsonde bereitgestellten signals den ersten oder zweiten Ausgangspegel erzeugen, wobei das Ausgangssignal entsprechend der Stromstärke des zu messenden Stromes pulsweitenmoduliert ist.

Im Vergleich zu manchen bekannten Kompensationsstromsensoren ist beim erfindungsgemäßen Stromsensor kein Regelkreis vorhanden. Statt dessen erfolgt eine Ansteuerung der Kompensationswicklung mit einem über der Zeit sich dreieckförmig ändernden, vorzugsweise bipolaren Strom. Die Ansteuerschaltung ist dabei freilaufend zwischen den zwei Scheitelpunkten (-Iₘₐₓ, +Iₘₐₓ) des dreieckförmigen, in die Kompensationswicklung eingespeisten Stromes, wobei auch die Frequenz frei wählbar ist und diese sich insbesondere am zu messenden Strom und an den Gegebenheiten des magnetischen Moduls orientiert. Das von der Magnetfeldsonde erzeugte Ausgangssignal wird außerhalb der Gleichgewichtsbedingung N·Iₖ = Ip die Sättigung der Magnetfeldsonde signalisieren, wobei N die Wicklungszahl der Kompensationswicklung, Iₖ der Kompensationsstrom und Ip der Primärstrom ist.

In unmittelbarer Nähe des Gleichgewichtszustandes tritt das Magnetfeldsondensignal in den linearen Bereich ein, läuft dann sehr exakt und steil durch den Nulldurchgang, um dann im weiteren Verlauf wieder im Sättigungsbereich zu verschwinden. Der Nulldurchgang selbst signalisiert den Gleichgewichtszustand, bei dem der Kompensationsstrom und der Primärstrom in einer festen Zuordnung zueinander stehen, so dass anhand des Kompensationsstromes dann eine Aussage über den Primärstrom getroffen werden kann. Der Nulldurchgang des Magnetsondensignals wird bei der Erfindung dazu benutzt, um einen Komparator zu schalten, der dann im Nulldurchgang umgeschaltet wird. Der Komparator kann beispielsweise entsprechend dem Vorzeichen des Magnetsondensignals einen entsprechenden logischen Pegel erzeugen. Das Vorzeichen des Magnetsondensignals ergibt sich dabei aus dem jeweiligen Umstand, ob das vom Primärstrom erzeugte Magnetfeld größer ist als das von der Kompensationswicklung erzeugte Magnetfeld oder umgekehrt.

Die Genauigkeit des erfindungsgemäßen Stromsensors hängt ab von der Linearität des Dreieckstromes, der aber in der Regel mit hoher Genauigkeit und einfachen Mitteln erzeugt werden kann. Der Messbereich zu hohen Strömen hin wird hauptsächlich durch den Betragsstromwert an den Extrempunkten des dreieckförmigen Kompensationsstroms festgelegt. Das Tastverhältnis des pulsweitenmodulierten Ausgangssignals gibt nun praktisch den Stromwert in Bruchteilen von diesem Spitzenwert an. Der Messbereich kann dann beliebig variiert werden, in dem man für den maximalen Kompensationsstrom (Extremwert) verschiedene Werte vorsieht.

Ein großer Vorteil des erfindungsgemäßen Stromsensors besteht auch darin, dass immer auch von selbst die Hysterese des beim magnetischen Modul verwendeten Magnetsensorkern ausgemittelt wird. Der Magnetsensorkern wird ständig definiert ummagnetisiert, wobei das pulsweitenmodulierte Signal einfach nur um dessen Hysterese verschoben ist.

Die Ansteuerschaltung, die den dreieckförmigen Kompensationsstrom in die Kompensationawicklung einspeist, kann dabei vorteilhafterweise auch gegen Masse arbeiten. Der Vorzeichenwechsel kann dann im Nulldurchgang durch Umschalten der Stromrichtung durch die Wicklung mittels entsprechender Schaltemetzwerke erzeugt werden. Solche Schalternetzwerke können beispielsweise Brückenschaltungen und dergleichen beinhalten.

Der eriindungsgemäße Stromsensor wird dabei mit einem magnetischen Modul betrieben , das zur Kopplung von Primärleiter, Kompensationswicklung und Magnetfeldsonde einen Kern mit Luftspalt aufweist, wobei der Kern den Primärleiter, umschließt. Der Magnetfelssensor, der bevorzugt induktiv arbeitet und dann eine Sensorwicklung mit Sensorkern aufweist, jedoch auch in Form eines Hall-Sensors realisiert sein könnte, ist vorzugsweise in dem Luftspalt angeordnet.

Bekannte Stromsensor an werden hingegen mit einem geschlossenen, den Primärleiter umschließenden Ringkern betrieben, wobei dann eine zusätzliche Wechselstrombeaufschlagung bzw. Wechselmagnetfeldbeaufschlagung erfolgt, um den Nulldurchgang der Hysteresekurve des Kerns detektieren zu können. Die Wechselstrombeaufschlagung bzw. Wechselmagnetfeldbeaufschlagung kann zum Beispiel mittels der Kompensationswicklung oder der Wicklung einer induktiven Magnetfeldsonde erfolgen. Die Frequenz der zusätzlichen Wechselstrombeaufschlagung ist dabei wesentlich höher als das Pulsweitenmodulationssignal, um eine ausreichend hohe Auflösung zu gewährleisten.

Die Erfindung wird nachfolgend anhand der in den Figuren der Zeichnung dargestellten Ausführungsbeispielen näher erläutert. Es zeigt:
- Figur 1: ein allgemeines Blockschaltbild eines erfindungsgemäßen Stromsensore,
- Figur 2: den zeitlichen Verlauf von Primärstrom, Kompensationsstrom und daraus resultierenden pulsweitenmodulierten Ausgangesignal bei einem erfindungsgemäßen Sensor nach Figur 1,
- Figur 3: ein Ausführungsbeispiel einer Ansteuerschaltung für einen erfindungsmäßen Stromsensor,
- Figur 4: ein magnetisches Modul mit Luftspalt für einen erfindungegemäßen Stromsensor und
- Figur 5: ein magnetisches Modul mit einem Ringkern bei einem bekannten Stromsensor.

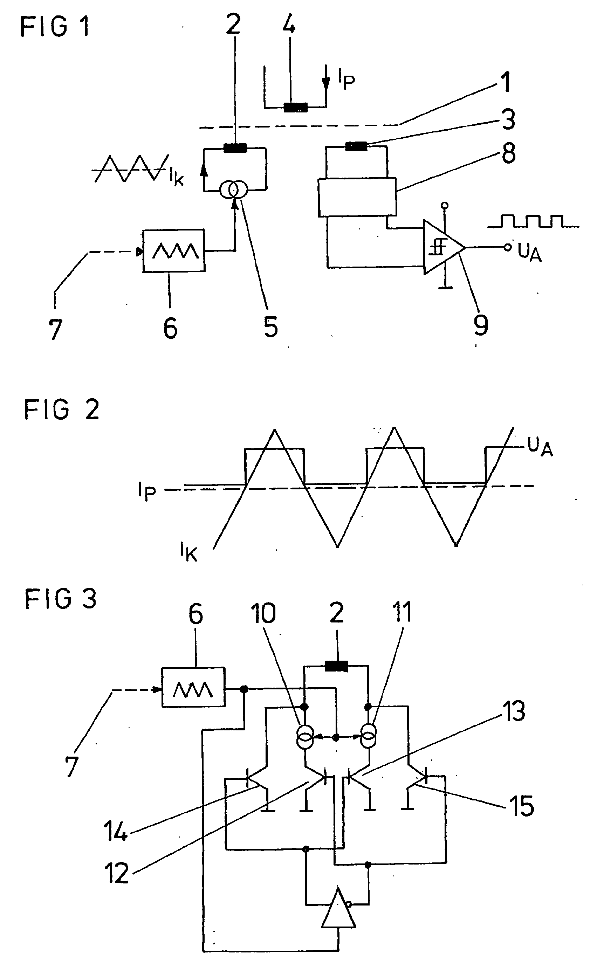

Bei dem Ausführungsbeispiel nach Figur 1 sind über einen Kern 1 eine Kompensationswicklung 2, eine Magnetfeldsonde 3 und ein Primärleiter 4 magnetisch miteinander gekoppelt. Beim vorliegenden Ausführungsbeispiel ist die Magnetfeldsonde induktiv ausgeführt. Der Primärleiter hat dabei keine Wicklungen, kann aber in gleicher Weise auch einige Wicklungen aufweisen, die auf den Kern 1 aufgebracht sind.

Die Kompensationswicklung 2 wird durch eine steuerbare bipolare Stromquelle 5 gespeist, die durch einen Dreieckssignalgenerator 6 gesteuert wird: Beim vorliegenden Ausführungsbeispiel ist der Dreieckssignalgenerator 6 so ausgebildet, dass seine Ausgangsamplitude über ein Steuersignal 7 einstellbar ist, wodurch auch die Amplitude des von der steuerbaren Stromquelle 5 erzeugten Kompensationsstroms einstellbar ist.

Die Wicklung des induktiven Stromsensors 3 ist mit einem Widerstand 8 abgeschlossen, wobei die an ihm abfallende Spannung einem Komparator 9 zugeführt wird, der je nach Vorzeichen der von einer Sondenelektronik 8 bereitgestellten Spannung einen logischen Pegel 1 oder 0 erzeugt. Um ein Schwingen des Komparators 9 in Nullpunktnähe bei Auftreten von Störungen zu vermeiden, hat dieser eine elektrische Hysterese, was heißt die Umschaltzeitpunkte bei positiver und negativer Flanke sind unterschiedlich. Am Ausgang des Komparators 9 ist dann ein entsprechend dem im Primärleiter 4 fließenden Primärstrom pulsweitenmoduliertes Ausgangssignal U_{A} abgreifbar.

Den Verlauf des Primärstroms Iₚ, des Kompensationsstrom Iₖ sowie des Ausgangssignals Uₐ ist in Figur 2 näher dargestellt. Wie daraus zu ersehen ist, ist der Kompensationsstrom Iₖ dreieckförmig zwischen den Extremwerten +Iₖ max und minus Iₖ. Hingegen wird der Primärstrom Ip im Beobachtungszeitraum als konstant angenommen. Einen dem entsprechenden Verlauf haben auch die durch den Kompensationsstrom Iₖ und den Primärstrom Ip erzeugten Magnetfelder im Kern 1. Der Einfachheit halber sei bei der Darstellung in Figur 2 angenommen, dass die Magnetfelder 1 zu 1 zu ihren jeweiligen Strömen sind. Danach steigt der Kompensationsstrom Iₖ und mit ihm sein Magnetfeld langsam an, wobei der Kompensationsstrom kleiner sei als der Primärstrom Iₚ. Solange der Kompensationsstrom kleiner ist als der Primärstrom IP gibt der Stromsensor 3 ein Signal mit negativen Vorzeichen ab. Dies wird vom Komparator 9 entsprechend diktiert und dem logischen Pegel 0 (entspricht beispielsweise 0V) bewertet. An dem Punkt, an dem Primärstrom Iₚ und Kompensationsstrom Iₖ gleich sind, das heißt ihre Magnetfelder gleich sind, kippt der Komparator 9 (abgesehen von einer kleinen Hysterese) um. Durch das weitere Ansteigen des Kompensationsstromes Iₖ ist nun der Kompensationsstrom Iₖ größer als der Primärstrom Iₚ. Entsprechend erhält das Ausgangssignal der Magnetfeldsonde ein positives Vorzeichen, so dass der Komparator 9 auf den logischen Pegel 1 (entspricht beispielsweise 5V) kippt. Das bedeutet, dass bei jedem Nulldurchgang das Ausgangssignal des Komparators 9 seinen Pegel wechselt. Während der anderen Zeit verharrt der Komparator auf einem dem jeweiligen Vorzeichen des Magnetfeldsondensignals entsprechenden Pegel. Der zugehörige Verlauf des Ausgangssignals U_{A} des Komparators 9 ist in Figur 2 ebenfalls dargestellt.

In Figur 3 ist eine besondere Ausführungsform einer Ansteuerschaltung gezeigt. Der besondere Vorteil der gezeigten Ansteuerschaltung liegt darin, dass die Kompensationswicklung 2 aus Figur 1 zwar bipolar gespeist wird, jedoch die Ansteuerschaltung selbst nur eine unipolare Spannungsversorgung benötigt. Zur Realisierung der Ansteuerschaltung sind zwei unipolare Stromquellen 10 und 11 vorgesehen, die beide in gleicher Weise durch den Dreiecksignalgenerator 6 gesteuert werden. Jeweils ein Anschluss der Stromquellen 10 und 11 ist dabei mit jeweils einem Anschluss der Kompensationswicklung 2 verbunden. Der jeweils andere Anschluss der Stromquellen 10 und 11 ist über die Laststrecke eines Halbleiterschalters 12 bzw. 13 auf Masse aufschaltbar.

Darüber hinaus sind auch die mit der Kompensationswicklung 2 verbundenen Anschlüsse der beiden Stromquellen 10 und 11 über Halbleiterschalter 14 und 15 auf Masse aufschaltbar. Als Halbleiterschalter kommen beispielsweise MOS-Feldeffekttransistoren, Bipolartransistoren, Insolated-Gate-Bipolartransistoren, Tyristoren usw. in Frage. Die Halbleiterschalter 12 bis 15 werden dabei so angesteuert, dass einer der beiden mit der jeweiligen Stromquelle 10 oder 11 verbundenen Halbleiterschalter 12, 14 bzw. 13, 15 sperrt und der jeweils andere leitet. Wobei die jeweils einer Stromquelle 10 oder 11 zugeordneten Transistorpaare invers zum anderen Transistorpaar angesteuert werden. Daraus ergibt sich, dass je nach Vorzeichen des vom Dreiecksignalgenerator 6 bereitgestellten Dreiecksignals ein Anschluss der Kompensationswicklung 2 direkt an Masse liegt und der jeweils andere auf die jeweilige Stromquelle aufgeschaltet ist. Somit wird ähnlich wie bei einer Brückenschaltung der maximal zur Verfügung stehende Strom ausgenutzt werden. Anstelle der gezeigten Anordnung können aber auch direkt Brückenschaltungen oder Mehrfachstromquellen in gleicher Weise benutzt werden.

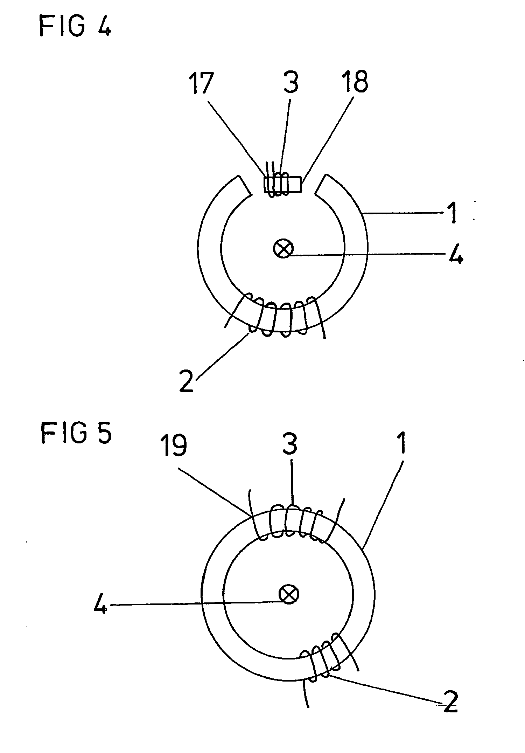

In Figur 4 ist eine bevorzugte Ausführungsform eines magnetischen Moduls gezeigt. Es handelt sich dabei um einen Ringkern 1a, der einen Luftspalt 16 aufweist. In dem Luftspalt 16 befindet sich eine Wicklung 17 mit Kern 13, die als Magnetfeldsonde 3 eingesetzt werden. Auf den Ringkern 1a selbst ist die Kompensationswicklung 2 aufgebracht. Der Primärleiter 4 ist schließlich wicklungslos durch den Ringkern hindurchgeführt. Alternativ kann natürlich der Primärleiter auch auf den Ringkern ähnlich der Kompensationswicklung 2 aufgewickelt sein.

Eine bekannte Ausführungsform eines magnetischen Moduls ist in Figur 5 gezeigt. Diese Ausführungsform unterscheidet sich von der in Figur 4 gezeigten, insbesondere dadurch, dass ein geschlossener Kern 1b vorgesehen ist. Als Magnetfeldsonde 3 dient hier eine Wicklung 19, die wie die Kompensationswicklung 2 auf den Kern aufgewickelt ist. In eine der beiden Wicklung wird ein zusätzlicher Wechselstrom eingespeist. Dieser zusätzliche Wechselstrom sollte in der Frequenz deutlich höher sein, als der dreieckförmige Kompensationsstrom. Übliche Größenordnungen sind beispielsweise 125Hz für den Kompensationestrom und 500 kHz für das zusätzliche Wechselstromsignal

## Patentansprüche

1. Stromsensor mit einem magnetischen Modul, bei dem ein Primärleiter, eine Kompensationswicklung und eine Magnetfeldsonde magnetisch miteinander gekoppelt sind, wobei der Primärleiter einen zu messenden Primärsstrom Iₚ führt,
mit einer Ansteuerschaltung zum Erzeugen eines zwichen zwei Scheitelpunkten (-Iₘₐₓ, +Iₘₐₓ) freilaufenden dreieckförmigen kompensationsstromes Iₖ, der in die Kompensationswicklung eingespeist wird, und
mit einer Auswerteschaltung, die bei einem Nulldurchgang eines von der Magnetfeldsonde bereitgestellten Signales ihr Ausgangssignal von einem ersten auf einen zweiten Ausgangspegel und umgekehrt umschaltet, wobei das Ausgangssignal entsprechend der Stromstärke des zu messenden Stromes pulsweitenmoduliert ist, wobei das magnetische Modul zur magnetischen Kopplung von Primärleiter, Kompensationswicklung und Magnetfeldsonde einen Kern mit Luftspalt aufweist, der den Primärleiter umschließt,
dadurch gekennzeicnhet, dass die Magnetfeldsonde in dem Luftspalt angeordnet ist, und
das Magnetfeldsondensignal in unmittelbarer Nähe des Gleichgewichtszustandes in den linearen Bereich eintritt, dann sehr exakt und steil durch den Nulldurchgang läuft, um dann im weiteren Verlauf wieder im Sättigungsbereich zu verschwinden, wobei der Gleichgewichtszustand dadurch gegeben ist, dass das Produkt aus der Wicklungszahl der Kompensationswicklung N und dem Kompensationsstrom Iₖ gleich dem Primärstrom Ip ist.

2. Stromsensor nach Anspruch 1, bei dem die Ansteuerschaltung einen bipolaren Strom erzeugt.

3. Stromsensor nach Anspruch 2, bei dem die Ansteuerschaltung einen Dreiecksgenerator zur Erzeugung eines dreieckförmigen Steuersignals und mindestens eine durch das Steuersignal gesteuerte Stromquelle aufweist.

4. Stromsensor nach Anspruch 3, bei dem die mindestens eine Stromquelle einen unipolaren Strom erzeugt, auf die mittels eines Schaltnetzwerkes die Kompensationswicklung entsprechend dem Vorzeichen des Steuersignals in der einen oder der anderen Richtung aufgeschaltet wird.

5. Stromsensor nach einem der vorherigen Ansprüche, bei dem der maximale von der Ansteuerschaltung bereitgestellte Strom einstellbar ist.

6. Stromsensor nach einem der vorherigen Ansprüche, bei dem die Auswerteschaltung einen Komparator aufweist, der das von der Magnetfeldsonde bereitgestellte Signal mit einem Nullpunkt vergleicht.

7. Stromsensor nach Anspruch 6, bei dem der Komparator eine elektrische Hysterese aufweist.

8. Stromsensor nach Anspruch 6 oder 7, bei dem die Auswerteschaltung ein unipolares pulsweitenmoduliertes Ausgangssignal erzeugt.

9. Stromsensor nach einem der vorherigen Ansprüche, bei dem die Magnetfeldsonde ein induktiver Sensor ist.

10. Stromsensor nach einem der vorherigen Ansprüche, bei dem die Auswerteschaltung abhängig von einem Vorzeichen eines von der Magnetfeldsonde bereitgestellten Signales einen ersten oder zweiten Ausgangspegel eines Ausgangsignals erzeugt, wobei das Ausgangsignal entsprechend der Stromstärke des zu messenden Stromes pulsweitenmoduliert ist.

## Claims

1. A current sensor
with a magnetic module in which a primary conductor, a compensation winding and a magnetic field probe are magnetically coupled to each other, whereby the primary conductor carries a primary current Iₚ to be measured,
with a control circuit for producing a triangular compensation current Iₖ running freely between two vertices (-lₘₐₓ, + lₘₐₓ) which is fed into the compensation winding, and
with an evaluation circuit that switches its output signal from a first to a second output level and inversely upon a zero passage of a signal made available from the magnetic field probe, whereby the output signal is modulated in its pulse width in accordance with the current strength of the current to be measured,
whereby the magnetic module comprises a core with an air gap for the magnetic coupling of the primary conductor, the compensation winding and the magnetic field probe which core surrounds the primary conductor,
**characterized in that** the magnetic field probe is arranged in the air gap, and
that the magnetic field probe signal enters into the linear area in the immediate vicinity of the equilibrium state and then runs very exactly and steeply through the zero passage in order to then disappear again in its further course in the saturation range, whereby the equilibrium state is given **in that** the product from the number of turns of the compensation winding N and the compensation current Iₖ is equal to the primary current Iₚ.

2. The current sensor according to claim 1, in which the control circuit produces a bipolar current.

3. The current sensor according to claim 2, in which the control circuit comprises a triangular generator for generating a triangular control signal and comprises at least one current source controlled by the control signal.

4. The current sensor according to claim 3, in which the at least one current source produces a unipolar current onto which the compensation winding is switched by a switching network in accordance with the sign of the control signal in the one or the other direction.

5. The current sensor according to one of the preceding claims, in which the maximum current made available by the control circuit is adjustable.

6. The current sensor according to one of the preceding claims, in which the evaluation circuit comprises a comparator that compares the signal made available by the magnetic field probe with a zero point.

7. The current sensor according to claim 6, in which the comparator comprises an electrical hysteresis.

8. The current sensor according to claim 6 or 7, in which the evaluation circuit produces a unipolar output signal modulated in its pulse width.

9. The current sensor according to one of the preceding claims, in which the magnetic field probe is an inductive sensor.

10. The current sensor according to one of the preceding claims, in which the evaluation circuit produces a first or a second output level of an output signal as a function of a sign of a signal made available by the magnetic field probe, whereby the output signal is modulated in its pulse width in accordance with the current strength of the current to be measured.

## Revendications

1. Détecteur de courant
comportant un module magnétique dans lequel un conducteur primaire, un enroulement de compensation et d'une sonde de champ magnétique sont couplés magnétiquement les uns aux autres, de sorte que le conducteur primaire porte un courant primaire Iₚ à mesurer,
comportant un circuit de commande pour produire un courant de compensation triangulaire Iₖ passant librement entre deux sommets (-lₘₐₓ, +lₘₐₓ) qui est alimenté dans l'enroulement de compensation, et
comportant un circuit d'exploitation qui fait commuter le signal de sortie d'un premier à un deuxième niveau de sortie et inversement lors du passage à zéro d'un signal mis à disposition à partir de la sonde de champ magnétique, de sorte que le signal de sortie est modulé dans sa largeur d'impulsion conformément à l'intensité de courant du courant à mesurer,
dans lequel le module magnétique comprend un noyau avec un entrefer pour le couplage magnétique du conducteur primaire, l'enroulement de compensation et la sonde de champ magnétique qui entoure le noyau du conducteur primaire,
**caractérisé en ce que** la sonde de champ magnétique est disposée dans l'entrefer,
et **en ce que** le signal de la sonde de champ magnétique pénètre dans la zone linéaire à proximité immédiate de l'état d'équilibre, puis tourne très exactement et rapidement à travers le passage à zéro de manière à disparaître ensuite à nouveau dans sa course ultérieure dans la plage de saturation, de sorte que l'état d'équilibre est donné par le fait que le produit du nombre de spires de l'enroulement de compensation N et le courant de compensation Iₖ est égal au courant primaire Iₚ.

2. Détecteur de courant selon la revendication 1, dans lequel le circuit de commande produit un courant bipolaire.

3. Détecteur de courant selon la revendication 2, dans lequel le circuit de commande comprend un générateur triangulaire pour produire un signal de commande triangulaire et comprend au moins une source de courant commandée par le signal de commande.

4. Détecteur de courant selon la revendication 3, dans lequel au moins la source de courant produit un courant unipolaire sur lequel l'enroulement de compensation est activé par un réseau de commutation en fonction du signe du signal de commande dans l'une ou l'autre direction.

5. Détecteur de courant selon l'une des revendications précédentes, dans lequel le courant maximal fourni par le circuit de commande est réglable.

6. Détecteur de courant selon l'une des revendications précédentes, dans lequel le circuit d'évaluation comprend un comparateur qui compare le signal fourni par la sonde de champ magnétique avec un point zéro.

7. Détecteur de courant selon la revendication 6, dans lequel le comparateur comprend une hystérésis électrique.

8. Détecteur de courant selon les revendications 6 ou 7, dans lequel le circuit d'évaluation produit un signal de sortie unipolaire modulé dans sa largeur d'impulsion.

9. Détecteur de courant selon l'une des revendications précédentes, dans lequel la sonde de champ magnétique est un capteur inductif.

10. Détecteur de courant selon l'une des revendications précédentes, dans lequel le circuit d'évaluation produit un premier ou un deuxième niveau de sortie d'un signal de sortie comme fonction d'un signe d'un signal fourni par la sonde de champ magnétique, de sorte que le signal de sortie est modulé dans sa largeur d'impulsion conformément à l'intensité de courant du courant à mesurer.
